# EUROPEAN PATENT APPLICATION

(11) **EP 4 300 575 A1**
(43) Date of publication of application: **03.01.2024**
(21) Application number: 23175256.9
(22) Date of filing: 25.05.2023
(51) Int. Cl.: H01L 23/538

(54) **INTERCONNECT BRIDGE WITH SIMILAR CHANNEL LENGTHS**

(30) Priority: 29.06.2022 US 202217853018
(71) Applicant: INTEL Corporation, Santa Clara, CA 95054 (US)
(72) Inventor: WANG, Lijiang, Chandler, 85249 (US); VISWANATHAN, Naren Sreenivas, Gilbert, 85295 (US); SHARAN, Sujit, Chandler, 85286 (US); SUN, Jiwei, Chandler, 85248 (US)
(74) Representative: 2SPL Patentanwälte PartG mbB

(57) **Abstract**

An electronic device may include an interconnect bridge. The interconnect bridge may include a first electrical routing trace having a first routing length and a corresponding first transit time for a first electrical signal to transmit across the first routing length. The first electrical routing trace may transmit the first electrical signal along a major plane of the interconnect bridge between a first interconnect and a second interconnect. The interconnect bridge may include a routing trace deviation in communication with the first electrical routing trace. The routing trace deviation is outside a direct route between the first interconnect and the second interconnect. The routing trace deviation may alter one or more of capacitance or resistance of the first electrical routing trace and correspondingly alter the first routing time.

## Description

### TECHNICAL FIELD

This document pertains generally, but not by way of limitation, to an electronic device having one or more electrical routing traces.

### BACKGROUND

An interconnect bridge electrically interconnects one or more electronic devices. For example, the interconnect bridge electrically interconnects a first die with a second die. The interconnect bridge is coupled with electrical interconnects (e.g., a bump, pad, solder ball, or the like) of the first die and the second die. The interconnect bridge includes a routing trace to transmit an electrical signal between the first die and the second die.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
- Figure 1: is a schematic diagram of an example of an electronic device.
- Figure 2: is a schematic diagram of yet another example of the electronic device of Figure 1.
- Figure 3: is a schematic diagram of still yet another example of the electronic device of Figure 1.
- Figure 4: is a schematic diagram of a further example of the electronic device of Figure 1.
- Figure 5: is a schematic diagram of an example of an interconnect bridge.
- Figure 6: is a schematic diagram of another example of the interconnect bridge of Figure 5.
- Figure 7: is a schematic diagram of yet another example of the interconnect bridge of Figure 5.
- Figure 8: is a schematic diagram of still yet another example of the interconnect bridge of Figure 5.
- Figure 9: is a schematic diagram of a further example of the interconnect bridge of Figure 5.
- Figure 10: is a schematic diagram of an additional example of the interconnect bridge of Figure 5.
- Figure 11: is one example of a method 1100 for manufacturing an electronic device (e.g., the electronic device of Figure 1, or the like).
- Figure 12: is a system level diagram, depicting an example of an electronic device (e.g., system) including one or more of the electronic device of Figure 1 or the interconnect bridge of Figure 5, as described in the present disclosure.

### DETAILED DESCRIPTION

The present inventors have recognized, among other things, that a problem to be solved may include electrically interconnecting one or more components of an electronic device. In some approaches, a first die (e.g., a semiconductor die, or the like) is coupled with a substrate, for instance a first level interconnect. The first level interconnect is coupled with die contacts of the first die (e.g., interconnects, bumps, pads, solder balls, pillars, or the like). In another approach, the first level interconnect is coupled with a motherboard. In yet another approach, a second die is coupled with a second substrate, such as a first level interconnect. The second die and its first level interconnect are coupled with the motherboard. In still yet another approach, the first die and the second die are indirectly coupled with the motherboard (e.g., using their respective first level interconnects, or the like). Accordingly, the first die and the second die may electrically communicate with each other using the motherboard. The electrical communication between the first die and the second die using the motherboard may limit the performance (e.g., data transfer rate, clock speed, or the like) of one or more of the first die and the second die. For instance, the distance (and associated time) to transfer an electrical signal between the first and second die using the motherboard may limit the performance of the electronic device.

The present subject matter may help provide a solution to this problem, such as with an interconnect bridge. In an example, the interconnect bridge is lithographically formed, for instance using one or more lithographic operations to create (e.g., define, manufacture, generate, produce, or the like) the interconnect bridge. In an example, the interconnect bridge may include one or more electrical routing traces. The electrical routing traces may be lithographically formed. The interconnect bridge may include a semiconductor material, for instance silicon. The interconnect bridge may include an organic material. The organic material may include carbon, or the like.

In an example, the interconnect bridge may facilitate electrical communication between the first die and the second die (or other components of an electronic device). For instance, the electronic device may include the interconnect bridge coupled with the die contacts of one or more of the first and second die. In another example, the interconnect bridge is directly coupled with the die contacts of one or more of the first die or the second die.

The interconnect bridge may include an electrical routing trace. The interconnect bridge may transmit one or more electrical signals between the first die and the second die using the electrical routing trace. Accordingly, the first die and the second die may electrically communicate using the interconnect bridge (instead of a motherboard and respective first level interconnects). In an example, the interconnect bridge may minimize distance electrical signals are transmitted between the first and second die. Thus, the interconnect bridge may enhance performance of the electronic device because the distance (and associated time) to transfer an electrical signal between the first die and the second die is reduced with the interconnect bridge (instead of the motherboard and respective first level interconnects).

In another example, the present inventors have recognized, among other things, that a problem to be solved may include minimizing differences in routing time between two or more channels of an electronic device. For instance, an electronic device may include a first electrical routing trace and a second electrical routing trace. The electronic device may use the first electrical routing trace as a first channel. The electronic device may use the second electrical routing trace as a second channel. The electronic device may include the first channel electrically isolated from the second channel. Accordingly, the electrical routing traces facilitate electrical communication between components of the electronic device.

In an example, the first routing trace has a first routing time to transmit an electrical signal across the first routing trace. The second routing trace has a second routing time to transmit an electrical signal across the second routing trace. In an example, the first routing time is based on one or more of the resistance or capacitance of the first electrical routing trace. In another example, the second routing time is based on one or more of the resistance or capacitance of the second electrical routing trace. Accordingly, alterations (e.g., changes, variations, revisions, or the like) in one or more of resistance or capacitance of the first electrical routing trace correspondingly alters the first routing time for the first electrical routing trace.

In some approaches, the first routing time is different than the second routing time. Accordingly, the length of time to transmit an electrical signal across the first routing trace may differ from the length of time to transmit an electrical signal across the second routing trace. The difference in time for electrical signals to transmit between components may decrease performance of the electronic device, for instance because the signals are distorted (or lost) due to the difference in timing for the signals to travel across the first and second electrical routing traces. In another example, the rate of data transfer between through the electronic device is limited by the difference in timing to transmit a signal across the first and second electrical routing traces. Thus, in some approaches, the electronic device may include a time delay (e.g., data swizzling, or the like) circuit, for instance to regulate transmission of electrical signals with a difference in routing time between channels of the electronic device.

The present subject matter may help provide a solution to this problem, such as with the interconnect bridge. In an example, the interconnect bridge includes an electrical routing trace having a trace deviation. The trace deviation may alter one or more of the capacitance or the resistance of the electrical routing trace. In an example, the routing time for a signal to transmit across the electrical routing trace is altered in correspondence with the alteration in capacitance or resistance of the electrical routing trace. For instance, the trace deviation may increase the length of the electrical routing trace, and correspondingly increase the routing time across the electrical routing trace.

In another example, the trace deviation enhances performance of an electronic device because the trace deviation allows for different channels of the electronic device to have similar routing times. For instance, the trace deviation may help minimize differences in routing times for electrical signals transmitted across the interconnect bridge. Accordingly, the routing times for each of the channels of the electronic device may be similar. Thus, the interconnect bridge minimizes differences between routing times without a time delay circuit to regulate the transmission of the electrical signals across the interconnect bridge. As a result, performance of the electronic device is enhanced because the similarity in routing times helps enhance speed of the electronic device. In another example, costs associated with manufacturing the device are minimized because the interconnect bridge provides similar routing times for channels without including a time delay circuit. Thus, the electronic device operates with specified timing across the channels without a time delay circuit. Accordingly, the interconnect bridge allows for exclusion of the time delay circuit within the electronic device (and correspondingly reduces costs to manufacture the electronic device without the time delay circuit).

In yet another example, the present inventors have recognized, among other things, that a problem to be solved may include electrically interconnecting electronic components with dissimilar contact patterns. For instance, the electronic components may include a first die and a second die. The first die may have a first contact pattern (e.g., ball grid array pattern, or the like). The second die may have a second contact pattern (e.g., ball grid array pattern, or the like). In some examples, the first contact pattern may differ from the second contact pattern. For instance, the contact patterns may differ in pitch, quantity, distribution, location, or the like (however the present subject matter is not so limited). The difference in contact patterns may decrease performance of the electronic device. For instance, the difference between contact patterns may limit data transmission rates between the first die and the second die. In another approach, the difference between contact patterns may limit interoperability between the first die and the second die.

In an approach, a first channel includes a first electrical routing trace. A second channel includes a second electrical routing trace. The routing time for the second routing trace may differ from the routing time for the first routing trace. For instance, a length of the first channel may be greater than a length of the second channel because the first contact pattern of the first die is different than the second contact pattern of the second die. Accordingly, in this approach, the first channel has greater resistance than the second channel. Thus, the routing time for the first channel is greater than the routing time for the second channel. The difference in routing times may decrease performance of the electronic device, for instance because the difference in routing times limits a data transfer rate between the first die and the second die. In another approach, the difference in routing times limits interoperability between the first die and the second die because the difference in routing times exceeds a specified time threshold (e.g., a fault occurs between the first die and the second die because of the difference in routing times, or the like).

The present subject matter may help provide a solution to this problem, such as with the interconnect bridge. In an example, the routing trace deviation alters one or more of resistance or capacitance of channels between the first die and the second die. Accordingly, the trace deviation minimizes differences between routing times for channels of the electronic device. Minimizing differences between routing times enhances performance of the electronic device. For instance, a data transfer rate between the first die and the second die is enhanced by minimizing differences in routing times for the channels between the first die and the second die. In another example, minimizing differences in routing times allows for the interconnect bridge to transmit electrical signals between components having dissimilar contact patterns. For example, the interconnect bridge may electrically interconnect the first die with the first contact pattern with the second die having the second contact pattern. In an example, the electronic device may include the interconnect bridge directly coupled with the contacts of the first and second dies. Accordingly, the interconnect bridge transmits signals between the first and second die. The interconnect bridge may minimize differences in routing times for the channels extending between the first and second die. Thus, the interconnect bridge may facilitate electrical communication between components of an electronic device having dissimilar contact patterns.

In yet another example, the trace deviation may tune the routing times for channels of the electronic device to correspond with a specified value. The trace deviation may tune the routing time for the electronic device to enhance interoperability (e.g., compatibility, or the like) of the components of the electronic device. For instance, the first die may lack interoperability with the second die due to time skew mismatch (e.g., a difference in routing times for channels interconnecting the die). The trace deviation may minimize time skew mismatch, and accordingly enhance interoperability between the first die and the second die.

Deviations from the specified value for the routing times may affect performance of the electronic device, for instance by limiting data transfer rates between the components. For example, the first die may expect to receive an electrical signal from the second die within a period of time that is less than the time it takes the electrical signal to transmit across the electrical routing trace between the first and second die. Accordingly, the first die may misinterpret or disregard the electrical signal (e.g., a fault may occur with respect to one or more functions of the electronic device). The trace deviation may tune one or more of resistance or capacitance (for the electrical routing trace) to minimize differences in routing times for channels of the electronic device. Accordingly, the interconnect bridge having a trace deviation may enhance compatibility between components of the electronic device. In an example, the interconnect bridge having the trace deviation may minimize differences in routing times due to differing contact patterns for the electronic components. Thus, the interconnect bridge having a trace deviation may enhance compatibility between components with differing contact patterns.

This overview is intended to provide an overview of subject matter of the present patent application. This overview is not intended to provide an exclusive or exhaustive explanation of the invention. The detailed description continues, and provides further information about the present patent application.

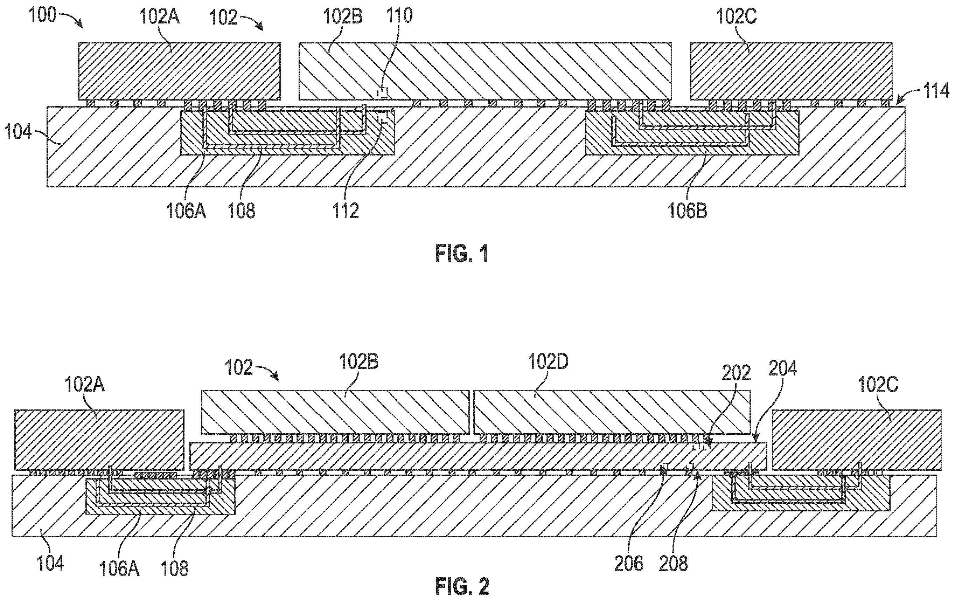

Figure 1 is a schematic diagram of an example of an electronic device 100. The electronic device 100 may include one or more die 102 coupled with a substrate 104. The substrate 104 may include a dielectric material. For example, the electronic device 100 may include one or more of a first die 102A, a second die 102B, or a third die 102C. The die 102 may include a semiconductor material. The die 102 may comprise one or more integrated circuits. The substrate 104 may facilitate communication between the die 102 (or other components of the electronic device 100).

In another example, the electronic device 100 may include one or interconnect bridges 106. The interconnect bridges 106 may facilitate communication between the die 102. For instance, the interconnect bridges 106 may include a semiconductor material. In yet another example, the interconnect bridges 106 may include one or more electrical routing traces 108. The electrical routing traces 108 may electrically interconnect the die 102 of the electronic device 100. For instance, the electronic device 100 may include a first interconnect bridge 106A electrically interconnecting the first die 102A with the second die 102B. In an example, a die contact 110 of the second die 102B is coupled with a bridge contact 112 of the interconnect bridge 102A. The die contact 110 and the bridge contact 112 may include (but are not limited to) one or more of a bump, pad, interconnect, pin, pillar, via, solder ball, or the like.

A second interconnect bridge 106B may electrically interconnect the second die 102B with the third die 106C. The first die 102A may transmit an electrical signal across the electrical routing traces 108 to the second die 102B. The third die 102C may transmit an electrical signal across the electrical routing traces 108 to the second die 102B. Accordingly, the die 102 may communicate using the interconnect bridges 106.

The substrate 104 may include the interconnect bridges 106. For instance, the substrate 104 may include the interconnect bridges 106 embedded within the substrate 104. In another example, the interconnect bridges 106 are recessed (e.g., located below) a surface 114 of the substrate 104. In yet another example, the interconnect bridges 106 are exposed on the surface 114 of the substrate 104.

Figure 2 is a schematic diagram of another example of the electronic device 100. The electronic device 100 may include the die 102, the substrate 104, and the interconnect bridges 106. The electronic device 100 may include an interposer 200. The interposer 200 may be passive, or the interposer 200 may be active. For instance, the interposer 200 may include one or more integrated circuits. In an example, the interposer 200 may improve one or more of signaling or power performance for the electronic device 100.

For instance, the electronic device 100 may include the interposer 200 between the die 102 and the substrate 104. The interposer 200 may transmit signals between components of the electronic device. In an example, the interposer 200 provides an interface between the die 102 and one or more of the substrate 104 or the interconnect bridges 106. For instance, the interposer 200 may facilitate electrical communication between electronic components having contacts with different patterns (e.g., different pitches, or the like). For instance, the interposer 200 may have a first set of interposer contacts 202 with a first pitch on a first side 204 of the interposer 200. The interposer 200 may have a second set of interposer contacts 206 with a second pitch on a second side 208 of the interposer 200. The interposer 200 may transmit electrical signals from the first set of interposer contacts 202 (on the first side 204) to the second set of interposer contacts 206 (on the second side 208).

The electronic device 100 may include a fourth die 102D. For instance, the electronic device 100 may include the second die 102B and the fourth die 102D coupled with the first side 202 of the interposer 200. The electronic device 100 may include the substrate 104 coupled with the second side 208 of the interposer 200. In another example, the electronic device 100 may include the interconnect bridges coupled with the interposer 200. For example, the first interconnect bridge 106A may transmit electrical signals between the first die 102A and the interposer 200 (or components coupled with the interposer 200, for example the second and fourth die 202B, 202D). The second interconnect bridge 106B may transmit electrical signals between the third die 102C and the interposer 200 (or components coupled with the interposer 200, for example the second and fourth die 202B, 202D). Accordingly, one or more of the substrate 104, the interconnect bridges 106, or the interposer 200 transmit electrical signals between components of the electronic device 100.

The die 102 may include an integrated circuit. In an example, the first die 102A may include a serializer/de-serializer. In another example, one or more of the second or fourth die 102B, 102D may include a field-programmable gate array. In yet another example, the third die 102C may include an application-specific integrated circuit. In still yet another example, the third die 102C may include an analog-to-digital/digital-to-analog converter. Accordingly, the electronic device 100 may include one or more integrated circuits coupled with the substrate 104.

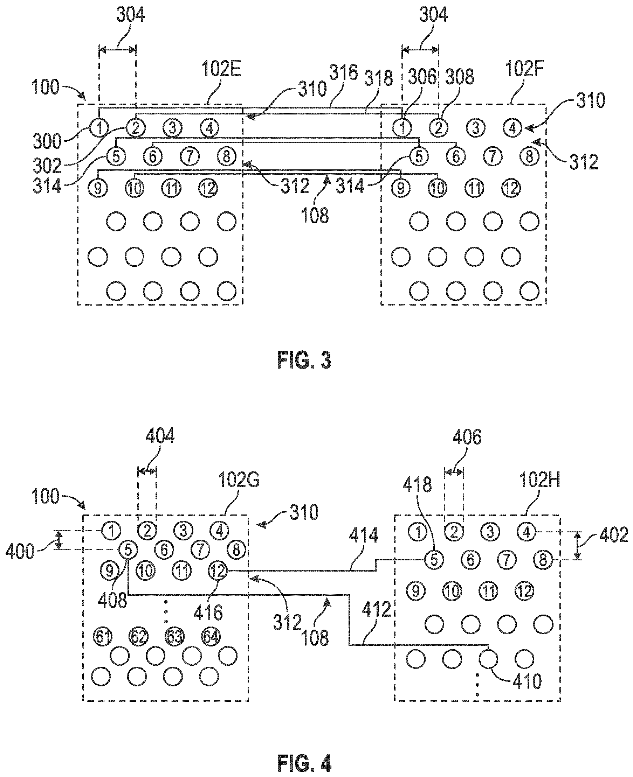

Figure 3 is a schematic diagram of yet another example of the electronic device 100. The electronic device 100 may include the one or more die 102, for instance a fifth die 102E and a sixth die 102F. The die 102E, 102F may have similar contact patterns. In an example, the die 102E has a first die contact 300 and a second die contact 302. The first die contact 300 may be separated from the second die contact 302 by a first pitch 304 (e.g., spacing, distance, distribution, increment, or the like). In another example, the die 102F may include a third die contact 306 and a fourth die contract 308. The third die contact 306 and the fourth die contact 308 may be separated by the first pitch 304. Accordingly, the contact pattern for the fifth die 102E may be similar to the contact pattern for the sixth die 102F.

In yet another example, electronic device 100 may include the first and second die contacts 300 within a first row 310 of contacts for the die 102E. A second row 312 of contacts for the die 102E may include a fifth die contact 314. Figure 3 shows the first row 310 of contacts may be offset (e.g., staggered, shifted, or the like) with respect to the second row 312 of contacts. For instance, the electronic device 100 may include the fifth die contact 314 offset with respect to the first die contact 300. In another example, the fifth die contact 314 may be located between the first die contact 300 and the second die contact 302 (and located in the second row 312). The die 102F may include the first row 310 and the second row 312 of contacts. For instance, the die 102F may include the fifth die contact 314 within the second row 312 of die contacts. Accordingly, the fifth die 102E may have a similar contact pattern to the sixth die 102F.

Figure 4 is a schematic diagram of a further example of the electronic device 100. The electronic device 100 may include the one or more die 102, for instance a seventh die 102G and an eighth die 102H. The die 102G, 102H may have dissimilar contact patterns. In an example, seventh die 102G may include the first row 310 of die contacts and the second row 312 of die contacts spaced at a second pitch 400. The eighth die 102H may include the first row 310 of die contacts and the second row 312 of die contacts spaced at a third pitch 402. For instance, Figure 4 shows the third pitch 402 may be greater than the second pitch 400. In another example, the die contacts of the die 102G may have a first size 404 (e.g., cross-sectional area, diameter, perimeter, volume, or the like). The die contacts of the die 102H may have a second size 406. Accordingly, the die contact pattern for the die 102G may be dissimilar to the die contact pattern for the die 102H.

Figure 3 shows the electrical routing traces 108 interconnecting the die 102E and die 102F (e.g., Figure 3) may be uniform. For instance, the electronic device 100 may electrically interconnect die contact 300 (of die 102E) with the die contact 306 (of die 102F) using a first electrical routing trace 316. A second electrical routing trace 318 may electrically interconnect the die contact 302 (of die 102E) with the die contact 308 (of die 102F). The first and second electrical routing traces 316, 318 may be uniform. For instance, the similarity between the die contact patterns for the die 102E, 102F facilitate uniformity for the electrical routing traces 316, 318. In an example, a first electrical signal transmitted across the electrical routing trace 316 may travel approximately the same distance (in approximately the same amount of time) as a second electrical signal transmitted across the electrical routing trace 318. For instance, an RC constant for the first electrical routing trace 316 may be similar to an RC constant for the second electrical routing trace 318. Accordingly, the die 102E, 102F may have similar contact patterns and correspondingly may have uniform electrical routing traces 316, 318 interconnecting the die 102E, 102F.

Figure 4 shows the electrical routing traces 108 interconnecting the die 102G, 102H may be non-uniform. For example, the electronic device 100 may electrically interconnect a sixth die contact 408 (of die 102G) with a seventh die contact 410 (of die 102H) using a third electrical routing trace 412. In another example, a fourth electrical routing trace 414 may electrically interconnect an eighth die contact 416 (of die 102G) with a ninth die contact 418 (of die 102H). The third and fourth electrical routing traces 412, 414 may be non-uniform. For instance, the dissimilarity between the die contact patterns for the die 102G, 102H facilitate the lack of uniformity for the electrical routing traces 412, 414. In an example, a first electrical signal transmitted across the electrical routing trace 412 may travel a longer distance (in a greater amount of time) than a second electrical signal transmitted across the electrical routing trace 414. For instance, an RC constant for the third electrical routing trace 412 may be greater than an RC constant for the fourth electrical routing trace 414. Accordingly, the die 102G, 102H may have dissimilar contact patterns and correspondingly may have non-uniform electrical routing traces 412, 414 interconnecting the die 102G, 102H.

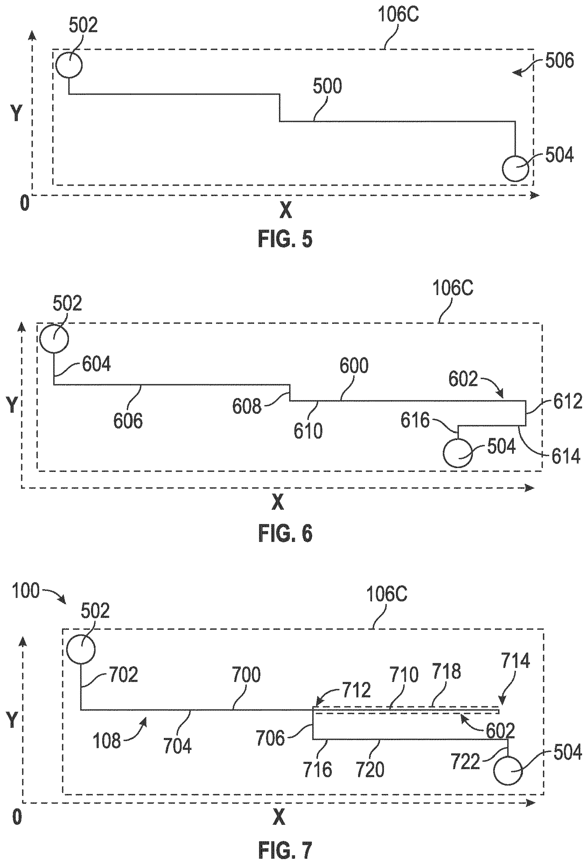

Figure 5 is a schematic diagram of an example of a third interconnect bridge 106C. In an example, the one or more interconnect bridges 106 may include the third interconnect bridge 106C. The third interconnect bridge 106C may include the electrical routing traces 108. For instance, the third interconnect bridge 106C may include a fifth electrical routing trace 500. The electrical trace 500 may electrically interconnect a first bridge contact 502 with a second bridge contract 504. The bridge contracts 502, 504 may couple with respective die contacts for the one or more die 102. Accordingly, the interconnect bridge 106C may transmit an electrical signal between the bridge contacts 502, 504 using the electrical routing trace 500.

Figure 5 shows the electrical routing trace 500 following a direct route between the bridge contacts 502, 504. In an example, the electrical routing trace 500 extends along a major plane 506 of the third interconnect bridge 106C. For instance, Figure 5 shows an X-axis and a Y-axis. The X-axis and Y-axis may define the major plane 506. The electrical routing trace 500 follows a direct route between bridge contacts 502, 504 because there are a lack of deviations for the electrical routing trace 500 along the route between the first bridge contact 502 and the second bridge contact 504. For instance, the second bridge contact 504 is located in a first direction (e.g., toward 0, toward the origin, or the like) along the Y-axis with respect to the first bridge contact 502. The second bridge contact 504 is located in a first direction (e.g., away from 0, away from the origin, or the like) along the X-axis with respect to the first bridge contact 502. The electrical routing trace 500 follows a direct route between the first bridge contact 502 and the second bridge contact 504 because the electrical routing trace 500 only extends in the first direction along the Y-axis and in the first direction along the X-axis. Thus, the electrical routing trace 500 lacks a deviation away from the first direction along the X-axis and lacks a deviation away from the first direction along the Y-axis. In another example, the electrical routing trace 500 may extend predominately in the first direction.

Figure 6 is a schematic diagram of another example of the third interconnect bridge 106C. Figure 6 shows a sixth electrical routing trace 600 extending between the first bridge contact 502 and the second bridge contact 504. The sixth electrical routing trace 600 may comprise a trace deviation 602. The trace deviation 602 may be located outside the direct route (shown in Figure 5) between the first bridge contact 502 and the second bridge contact 504. The trace deviation 602 may alter an RC value (and associated routing time) for the sixth electrical routing trace 600 (in comparison to the electrical routing trace 500, shown in Figure 5). In an example, the RC value for the sixth electrical routing trace 600 corresponds with a product of the resistance for the sixth electrical routing trace 600 and capacitance for the sixth electrical routing trace 600. Accordingly, an alteration in resistance for the sixth electrical routing trace 600 correspondingly alters the RC value for the sixth electrical routing trace 600. For instance, the trace deviation 602 may increase overall length of the sixth electrical routing trace 600. An increase in length for the sixth electrical routing trace 600 correspondingly increases the resistance of the sixth electrical routing trace 600. Accordingly, the trace deviation 602 may alter an RC value of the sixth electrical routing trace 600.

For instance, the sixth electrical routing trace 600 may comprise a first section 604 and a second section 606. The first section 604 is coupled with the first bridge contact 502, and the first section 604 extends in the first direction along the Y-axis (e.g., toward 0, toward the origin, or the like). The second section 606 is coupled with the first section 604, and the second section 606 extends in the first direction along the X-axis (e.g., away from 0, away from the origin, or the like). A third section 608 of the electrical routing trace 600 is coupled with the second section 606. The third section 608 extends in the first direction along the Y-axis. A fourth section 610 of the sixth electrical routing trace 600 is coupled with the third section 608. The fourth section 610 extends in the first direction along the Y-axis.

Figure 6 shows the fourth section 610 extending beyond the second bridge contact 504 with respect to the X-axis. In an example, the fourth section extends outside a region between the first bridge contact 502 and the second bridge contact 504. Accordingly, the fourth section 610 is outside the direct route (shown in Figure 5) between the first bridge contact 502 and the second bridge contact 504. The trace deviation 602 may comprise the fourth section 610. For instance, the fourth section 610 may partially extend along the direct route (e.g., between the bridge contacts 502, 504, or the like) before deviating outside the direct route (e.g., beyond the second bridge contact 504 with respect to the X-axis, or the like). Thus, Figure 6 shows the trace deviation 602 is outside the direct route between the first bridge contact 502 and the second bridge contact 504. In another example, the trace deviation 602 may extend in a second direction (e.g., different than the first direction, for instance an opposite direction or the like). In another example, a fifth section 612 of the electrical routing trace 600 is beyond the second bridge contact 504 with respect to the X-axis. For instance, the fifth section 612 is coupled with the fourth section 610 (outside the region between die contacts 502, 504). The fifth section 612 extends in the first direction along the Y-axis. The trace deviation 602 may comprise the fifth section 612. Thus, the fifth section 612 is outside the direct route between the first bridge contact 502 and the second bridge contact 504. Accordingly, the trace deviation 602 is outside the direct route between the bridge contacts 502, 504.

In yet another example, a sixth section 614 of the electrical routing trace 600 is coupled with the fifth section 612 (shown in Figure 6). The sixth section 614 extends in a second direction (e.g., toward 0, toward the origin, or the like) with respect to the X-axis. The fifth section 612 is beyond the second bridge contact 504 with respect to the X-axis (e.g., outside a region between the first bridge contact 502 and the second bridge contact 504). Accordingly, the fifth section 612 is outside the direct route between the first bridge contact 502 and the second bridge contact 504. Thus, the trace deviation 602 may comprise the sixth section 614.

Figure 6 shows a sixth section 616 coupled with the fifth section 612. The sixth section 616 extends in the first direction along the Y-axis. The sixth section 616 is coupled with the second bridge contact 504. The sixth section 616 is within the direct route between the first bridge contact 502 and the second bridge contact 504. Accordingly, the sixth section 616 is not included in the trace deviation 602. For instance, the sixth section 616 is within a region between the first bridge contact 502 and the second bridge contact 504. In another example, the sixth section 616 and the fourth section 610 are within the same region along the X-axis (and spaced apart along the Y-axis). For instance, Figure 6 shows both the sixth section 616 and the fourth section 610 outside the region between die contacts 502, 504. Thus, the trace deviation 602 may include one or more of the fourth section 610, fifth section 612, or the sixth section 614. In another example, Figure 6 shows the trace deviation 602 back-staggering (e.g., dog-legging, zig-zagging, hooking, meandering, or the like) the sixth electrical routing trace 600 because the sections 610, 612, 614 are outside the region between die contacts 502, 504. A person having ordinary skill in the art will appreciate that the number of sections for the electrical routing trace 600 may vary from the example provided herein.

Figure 7 is a schematic diagram of yet another example of the third interconnect bridge 106C. Figure 7 shows a seventh electrical routing trace 700 extending between the first bridge contact 502 and the second bridge contact 504. The electrical routing trace 700 may comprise the trace deviation 602. The trace deviation 602 may be located outside the direct route (shown in Figure 5) between the first bridge contact 502 and the second bridge contact 504.

For instance, the electrical routing trace 700 may comprise a first section 702 and a second section 704. The first section 702 is coupled with the first bridge contact 502, and the first section 702 extends in the first direction along the Y-axis (e.g., toward 0, toward the origin, or the like). The second section 704 is coupled with the first section 702, and the second section 704 extends in the first direction along the X-axis (e.g., away from 0, away from the origin, or the like). A third section 706 of the electrical routing trace 700 is coupled with the second section 704. The third section 706 extends in the first direction along the Y-axis.

Figure 7 shows the trace deviation 602 may comprise a capacitive loading wing 710. In an example, a first end 712 of the capacitive loading wing 710 is coupled with the electrical routing trace 700. For instance, the first end 712 is coupled to the electrical routing trace 700 at an intersection between the second section 704 and the third section 706. The capacitive loading wing 710 extends between the first end 712 and a second end 714. The capacitive loading wing 710 extends in the first direction along the X-axis from the first end 712 toward the second end 714 of the capacitive loading wing 710.

In an example, the one or more electrical routing traces 108, (including, but not limited to, the electrical routing trace 700) include a conductive material 716 to transmit an electrical signal between components of the electronic device 100 (shown in Figure 1 and 2). The conductive material 716 may include, but is not limited to, copper, gold, aluminum, or the like.

In another example, the electronic device 100 includes a dielectric material 718. For instance, the electronic device 100 may include the dielectric material 718 coupled along the electrical routing traces 108. Accordingly, the dielectric material 718 may electrically isolate portions of the electrical routing traces 108 from other components of the electronic device. For instance, the dielectric material 718 may be coupled with the capacitive loading wing 710. In yet another example, the second end 714 of the capacitive loading wing 710 is electrically isolated from other components of the electronic device 100. The dielectric material 718 may electrically isolate the second end 714 of the capacitive loading wing 710 from the other components of the electronic device 100.

Referring to Figure 7, a fourth section 720 of the seventh electrical routing trace 700 is coupled with the third section 706. The fourth section 610 extends in the first direction along the X-axis. A fifth section 722 of the electrical routing trace 700 is coupled with the fourth section 720. The fifth section 722 is coupled with the second bridge contact 504. The fifth section 722 extends in the first direction along the Y-axis.

The first section 702, second section 704, third section 706, fourth section 720, and the fifth section 722 are within the direct route between the first bridge contact 502 and the second bridge contact 504. For instance, the sections 702, 704, 706, 720, 722 are within a region between the bridge contacts 502, 504. The capacitive loading wing 710 is outside the direct route between the first bridge contact 502 and the second bridge contact 504. For instance, the capacitive loading wing 710 and the fourth section 720 are within the same region along the X-axis (and spaced apart along the Y-axis). Accordingly, the capacitive loading wing 710 is outside the direct route because the capacitive loading wing 710 deviates outside the direct route at the intersection between third section 706 and fourth section 720. In another example, the capacitive loading wing 710 is outside the direct route because the second end 714 of the capacitive loading wing 710 is electrically isolated. For instance, an electrical signal is not transmitted to another section (e.g., the fifth section 722, or the like) of the electrical routing trace 700 from the second end 714 of the capacitive loading wing 710. Thus, the fourth section 720 is within the direct route between contacts 502, 504 and the capacitive loading wing 710 deviates from the direct route (e.g., at the intersection between the sections 704, 706, or the like). A person having ordinary skill in the art will appreciate that the number of sections for the electrical routing trace 700 may vary from the example provided herein.

The trace deviation 602 may alter an RC value (and associated routing time) for the seventh electrical routing trace 700 (in comparison to the electrical routing trace 500, shown in Figure 5). In an example, the capacitive loading wing 710 alters (e.g., changes, varies, revises, or the like) capacitance of the electrical routing trace 700. In an example, the capacitive loading wing 710 provides an increase in area for a capacitor. The capacitor may comprise the seventh routing trace 700. Thus, capacitance of the electrical routing trace may increase with the capacitive loading wing 710 included in the interconnect bridge 106C. The capacitive loading wing 710 may increase capacitance of the seventh electrical routing trace 700. Accordingly, the trace deviation 602 may alter an RC value of the seventh electrical routing trace 700.

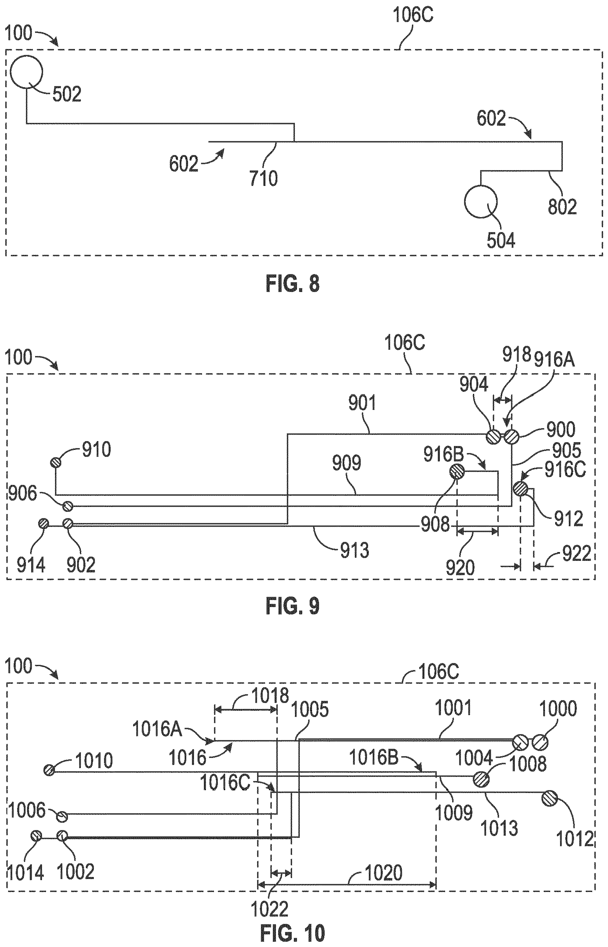

Figure 8 is a schematic diagram of still yet another example of the third interconnect bridge 106C. Figure 8 shows an eighth electrical routing trace 800. The eighth electrical routing trace 800 may include one or more of the capacitive loading wing 710 or a back-staggered section. For instance, the trace deviation 602 may comprise the capacitive loading wing 710. In another example, the trace deviation 602 includes one or more sections outside the region between the first bridge contact 502and the second bridge contact 504. For instance, a first section 802 of the electrical routing trace 800 is outside the direct route between the first bridge contact 502 and the second bridge contact 504. Accordingly, the eighth electrical routing trace 800 may include one or more of the capacitive-loading wing 700 or a back-staggered section (e.g., the first section 802, or the like). Thus, one or more of the capacitive-loading wing 700 or the back-staggered section alter the RC value of the eighth electrical routing trace 800 (in comparison to the electrical routing trace 500 following the direct route between contacts 502, 504 - shown in Figure 5).

Figure 9 is a schematic diagram of a further example of the third interconnect bridge 106C. The third interconnect bridge 106C may include one or more contacts, for instance a first bridge contact 900 and a second bridge contract 902. A first electrical routing trace 901 facilitates transmission of an electrical signal between the first bridge contact 900 and the second bridge contract 902. The first electrical routing trace 901 follows a direct route between the first bridge contact 900 and the second bridge contract 902. In an example, the first bridge contact 900 may couple with a die contact of a first die (e.g., die 102A, shown in Figure 1). The second bridge contract 902 may couple with a die contact of a second die (e.g., die 102B, shown in Figure 1).

In another example, the third interconnect bridge 106C may include a third bridge contact 904 and a fourth bridge contact 906. A second electrical routing trace 905 facilitates transmission of an electrical signal between the third bridge contact 904 and the fourth bridge contact 906. The third interconnect bridge 106C may include a fifth bridge contact 908 and a sixth bridge contact 910. A third electrical routing trace 909 facilitates transmission of an electrical signal between the fifth bridge contact 908 and the sixth bridge contact 910. The third interconnect bridge 106C may include a seventh bridge contact 912 and an eighth bridge contact 914. A fourth electrical routing trace 913 facilitates transmission of an electrical signal between the third bridge contact 904 and the fourth bridge contact 906.

Referring to Figure 9, the second electrical routing trace 905, third electrical routing trace 909, and the fourth electrical routing trace 913 each include a back-staggered section 916. For instance, the second electrical routing trace 905 includes one or more sections outside the region between the first bridge contact 900 and the second bridge contract 902. The third electrical routing trace 909 includes one or more sections outside the region between the fifth bridge contact 908 and the sixth bridge contact 910. The fourth electrical routing trace 913 includes one or more sections outside the region between the seventh bridge contact 912 and the eighth bridge contact 914.

For instance, the first electrical routing trace 901 follows a direct route between the first bridge contact 900 and the second bridge contract 902. The second electrical routing trace 905 is outside the direct route between the third bridge contact 904 and the fourth bridge contact 906. The third electrical routing trace 909 is outside the direct route between the fifth bridge contact 908 and the sixth bridge contact 910. The fourth electrical routing trace 913 is outside the direct route between the seventh bridge contact 912 and the eighth bridge contact 914.

The back-staggered sections 916 facilitate tuning of the resistance of the electrical routing traces 905, 909, 913. For instance, tuning the resistance for the electrical routing traces 905, 909, 913 may alter an RC value for the electrical routing traces 905, 909, 913. The RC value (e.g., RC time constant, or the like) for the individual electrical routing traces 901, 905, 909, 913 may be associated with respective individual routing times for an electrical signal to transmit across the individual ones of the electrical routing traces 901, 905, 909, 913. Accordingly, tuning the resistance of the electrical routing traces 905, 909, 913 may correspondingly alter the routing time for the electrical routing traces 905, 909, 913.

In an example, each of the second, third, and fourth electrical routing traces 905, 909, 913 may be tuned (with back-staggered sections 916) to minimize time skew with respect to the first electrical routing trace 901. Time skew may include a difference in routing times between the electrical routing traces 901, 905, 909, 913. The back-staggered sections 916 may facilitate tuning of the routing times for electrical routing traces 905, 909, 913 to correspond with the routing time of the first electrical routing trace 901.

In an example, a first back-staggered section 916A may alter the RC value (and associated routing time) for the second electrical routing trace 905 to correspond with the first electrical routing trace 901. A second back-staggered section 916B may alter the RC value (and associated routing time) for the third electrical routing trace 909 to correspond with the first electrical routing trace 901. A third back-staggered section 916C may alter the RC value (and associated routing time) for the fourth electrical routing trace 913 to correspond with the first electrical routing trace 901. Accordingly, the back-staggered sections 916 may minimize time skew between the first, second, third, and fourth electrical routing traces 901, 905, 909, 913.

For example, the back-staggered sections 916 alter overall length of each of the electrical routing traces 905, 909, 913. Thus, the back-staggered sections 916 may alter resistance of each of the electrical routing traces 905, 909, 913. Accordingly, the back-staggered sections 916 may alter RC values for each of the electrical routing traces 905, 909, 913. In an example, the second electrical routing trace 905 may include first back-staggered section 916A having a first back-stagger dimension 918. The first back-stagger dimension 918 increases the overall length of the second electrical routing trace 905 by a first amount (and correspondingly increases the resistance of the second electrical routing trace 905 by a first amount). Thus, the first back-staggered section 916A may alter the RC value of the second electrical routing trace 905 to correspond with the RC value of the first electrical routing trace 901.

In another example, the third electrical routing trace 909 may include second back-staggered section 916B having a second back-stagger dimension 920. The second back-stagger dimension 920 increases the overall length of the third electrical routing trace 909 by a second amount (and correspondingly increases the resistance of the third electrical routing trace 909 by a second amount). Accordingly, the second back-staggered section 916B may alter the RC value of the third electrical routing trace 909 to correspond with the RC value of the first electrical routing trace 901.

In yet another example, the fourth electrical routing trace 913 may include third back-staggered section 916C having a third back-stagger dimension 922. The third back-stagger dimension 922 increases the overall length of the fourth electrical routing trace 913 by a third amount (and correspondingly increases the resistance of the electrical routing trace 913 by a third amount). Thus, the third back-staggered section 916C may alter the RC value of the fourth electrical routing trace 913 to correspond with the RC value of the first electrical routing trace 901. In still yet another example, a correspondence between RC values for each of the electrical routing traces 901, 905, 909, 913 may minimize differences in routing times between the electrical routing traces 901, 905, 909, 913.

The first back-stagger dimension 918 may differ from the second back-stagger dimension 920. The first back-stagger dimension 918 may differ from the third back-stagger dimension 922. The second back-stagger dimension 920 may differ from the third back-stagger dimension 922. Accordingly, the resistance across each of the back-staggered sections 9 916A, 916B, 916C may differ with respect to other ones of the back-staggered sections 916A, 916B, 916C. Thus, the back-staggered sections 916A, 916B, 916C may alter RC values for each of the electrical routing traces 905, 909, 913 (respectively). As a result, the back-staggered sections 916A, 916B, 916C may minimize differences in routing times between the electrical routing traces 901, 905, 909, 913.

Minimizing differences between routing times across the electrical routing traces 901, 905, 909, 913 enhances performance of the electronic device 100. For instance, a data transfer rate between a first die (e.g., die 102G, shown in Figure 4, or the like) and a second die (e.g., die 102H, shown in Figure 4, or the like) is enhanced by minimizing differences in routing times for the channels between the first die and the second die. A channel may include one or more of the electrical routing traces 108. In another example, minimizing differences in routing times allows for the interconnect bridge 106C to transmit electrical signals between components having dissimilar contact patterns. For example, the interconnect bridge 106C may electrically interconnect the first die with a first contact pattern with the second die having a second (different) contact pattern. The interconnect bridge 106C may directly couple with die contacts of the first and second dies. Accordingly, the interconnect bridge 106C may transmit signals between the first and second die. The interconnect bridge 106C may minimize differences in routing times for the channels extending between the first and second die. Thus, the interconnect bridge 106C facilitates electrical communication between components of an electronic device having dissimilar contact patterns.

In yet another example, the back-staggered sections 916 may tune the routing times of the electrical routing traces 918 to correspond with a specified value. The back-staggered sections may tune the routing times for the electronic device to enhance compatibility of the components of the electronic device. For instance, the first die may lack compatibility with the second die due to time skew mismatch (e.g., a difference in routing times for channels interconnecting the die, or the like). The back-staggered sections 916 minimize time skew mismatch, and accordingly enhances compatibility between the first die and the second die.

Deviations from the specified value for the routing times may affect performance of the electronic device 100, for instance by limiting data transfer rates between components of the electronic device 100. For example, the first die (e.g., die 102G, shown in Figure 4, or the like) may expect to receive an electrical signal from the second die (e.g., die 102H, shown in Figure 4, or the like) within a period of time that is less than the time it takes the electrical signal to transmit across the routing trace (e.g., traces 412, 414 - shown in Figure 4, or the like) between the first and second die. Accordingly, the first die may misinterpret or disregard the electrical signal (e.g., a fault may occur with respect to one or more functions of the electronic device). The back-staggered sections 916 may tune one or more of resistance or capacitance to minimize differences in routing times for channels of the electronic device 100. Accordingly, the interconnect bridge 106C (shown in Figure 9) having a trace deviation enhances compatibility between components of the electronic device 100.

Figure 10 is a schematic diagram of an additional example of the third interconnect bridge 106C. The third interconnect bridge 106C may include one or more contacts, for instance a first bridge contact 1000 and a second bridge contract 1002. A first electrical routing trace 1001 facilitates transmission of an electrical signal between the first bridge contact 1000 and the second bridge contract 1002. The first electrical routing trace 1001 follows a direct route between the first bridge contact 1000 and the second bridge contract 1002. In an example, the first bridge contact 1000 may couple with a die contact of a first die (e.g., die 102A, shown in Figure 1, or the like). The second bridge contract 1002 may couple with a die contact of a second die (e.g., die 102B, shown in Figure 1, or the like).

In another example, the third interconnect bridge 106C may include a third bridge contact 1004 and a fourth bridge contact 1006. A second electrical routing trace 1005 facilitates transmission of an electrical signal between the third bridge contact 1004 and the fourth bridge contact 1006. The third interconnect bridge 106C may include a fifth bridge contact 1008 and a sixth bridge contact 1010. A third electrical routing trace 1009 facilitates transmission of an electrical signal between the fifth bridge contact 1008 and the sixth bridge contact 1010. The third interconnect bridge 106C may include a seventh bridge contact 1012 and an eighth bridge contact 1014. A fourth electrical routing trace 1013 facilitates transmission of an electrical signal between the third bridge contact 1004 and the fourth bridge contact 1006.

The second electrical routing trace 1005, third electrical routing trace 1009, and the fourth electrical routing trace 1013 each include one or more capacitive loading wings 1016. The second electrical routing trace 1005 includes a first capacitive loading wing 1016A. The capacitive loading wing 1016A is outside the direct route between the third bridge contact 1004 and the fourth bridge contact 1006. For instance, capacitive loading wing 1016A is within the same region along the X-axis (and spaced apart along the Y-axis) as other sections of the second electrical routing trace 1005. Accordingly, the capacitive loading wing 710A is outside the direct route because the capacitive loading wing 710 deviates outside the direct route 720. In another example, the capacitive loading wing 710A is outside the direct route an end (e.g., the second end 714, shown in Figure 7, or the like) of the capacitive loading wing 710A is electrically isolated. For instance, an electrical signal is not transmitted to another section (e.g., the fifth section 722, shown in Figure 7, or the like) of the electrical routing trace 1005 from the end of the capacitive loading wing 710A.

In another example, the third electrical routing trace 1009 includes a second capacitive loading wing 710B. The capacitive loading wing 1016B is outside the direct route between the fifth bridge contact 1008 and the sixth bridge contact 1010. The fourth electrical routing trace 1013 includes a third capacitive loading wing 1016C. The capacitive loading wing 1016C is outside the direct route between the seventh bridge contact 1012 and the eight bridge contact 1014. The first electrical routing trace 1001 follows a direct route between the first bridge contact 1000 and the second bridge contract 1002.

The capacitive loading wings 1016 facilitate tuning of the capacitance of the electrical routing traces 1005, 1009, 1013. For instance, tuning the capacitance for the electrical routing traces 1005, 1009, 1013 may alter an RC value for the electrical routing traces 1005, 1009, 1013. The RC value (e.g., RC time constant, or the like) for the individual electrical routing traces 1001, 1005, 1009, 1013 may be associated with respective individual routing times for an electrical signal to transmit across the individual ones of the electrical routing traces 1001, 1005, 1009, 1013. Accordingly, tuning the capacitance of the electrical routing traces 1005, 1009, 1013 may correspondingly alter the routing time for the electrical routing traces 1005, 1009, 1013.

In an example, each of the second, third, and fourth electrical routing traces 1005, 1009, 1013 may be tuned (with one or more of the back-staggered sections 916 - shown in Figure 9, or the capacitive loading wings 1016 - shown in Figure 10, or the like) to minimize time skew with respect to the first electrical routing trace 1001. Time skew may include a difference in routing times between the electrical routing traces 1001, 1005, 1009, 1013. The capacitive loading wings 1016 may facilitate tuning of the routing times for electrical routing traces 1005, 1009, 1013 to correspond with the routing time of the first electrical routing trace 1001.

In an example, the first capacitive loading wing 1016A may alter the RC value (and associated routing time) for the second electrical routing trace 1005 to correspond with the first electrical routing trace 1001. The second capacitive loading wing 1016B may alter the RC value (and associated routing time) for the third electrical routing trace 1009 to correspond with the first electrical routing trace 1001. The third capacitive loading wing 1016C may alter the RC value (and associated routing time) for the fourth electrical routing trace 1013 to correspond with the first electrical routing trace 1001. Accordingly, the capacitive loading wings 1016 minimize time skew between the first, second, third, and fourth electrical routing traces 1001, 1005, 1009, 1013.

In an example, the second electrical routing trace 1005 may include first capacitive loading wing 1016A having a first wing dimension 1018. The first wing dimension 1018 alters capacitance of the electrical routing trace 1005 by a first amount. Thus, the first capacitive loading wing 1016A may alter the RC value of the second electrical routing trace 1005 to correspond with the RC value of the first electrical routing trace 1001.

In another example, the third electrical routing trace 1009 may include second capacitive loading wing 1016B having a second wing dimension 1020. The second wing dimension 1020 alters capacitance of the electrical routing trace 1009 by a second amount. Thus, the second capacitive loading wing 1016B may alter the RC value of the third electrical routing trace 1009 to correspond with the RC value of the first electrical routing trace 1001.

In yet another example, the fourth electrical routing trace 1013 may include third capacitive loading wing 1016C having a third wing dimension 1022. The third wing dimension 1022 alters capacitance of the electrical routing trace 1013 by a third amount. Thus, the third capacitive loading wing 1016C may alter the RC value of the fourth electrical routing trace 1013 to correspond with the RC value of the first electrical routing trace 1001. In still yet another example, a correspondence between RC values for each of the electrical routing traces 1001, 1005, 1009, 1013 may minimize differences in routing times between the electrical routing traces 1001, 1005, 1009, 1013.

Referring to Figure 10, the first wing dimension 1018 may differ from the second wing dimension 1020. The first wing dimension 1018 may differ from the third wing dimension 1022. The second wing dimension 1020 may differ from the third wing dimension 1022. Accordingly, the alter in capacitance for the capacitive loading wings 1016A, 1016B, 1016C may differ with respect to other ones of the capacitive loading wings 1016A, 1016B, 1016C. Thus, the capacitive loading wings 1016A, 1016B, 1016C may alter RC values for each of the electrical routing traces 1005, 1009, 1013 (respectively). As a result, the capacitive loading wings 1016A, 1016B, 1016C may minimize differences in routing times between the electrical routing traces 1001, 1005, 1009, 1013.

In yet another example, the capacitive loading wings 1016 may tune the routing times of the electrical routing traces 1018 to correspond with a specified value. The capacitive loading wings 1016 may tune the routing times for the electronic device 100 to enhance compatibility of the components of the electronic device. For instance, a first die (e.g., die 102G, shown in Figure 4, or the like) may lack compatibility with a second die (e.g., die 102H, shown in Figure 4, or the like) due to time skew mismatch (e.g., a difference in routing times for channels interconnecting the die, or the like). The capacitive loading wings 1016 minimize time skew mismatch, and accordingly enhances compatibility between the first die and the second die.

The routing trace deviations (e.g., one or more of the back-staggered sections 916 - shown in Figure 9, or the capacitive loading wings 1016 - shown in Figure 10, or the like) tune one or more of resistance or capacitance to minimize differences in routing times for channels of the electronic device 100. Accordingly, the interconnect bridge 106C (shown in Figure 10) having a trace deviation enhances compatibility between components of the electronic device 100.

In some examples, a multiplicative factor may be applied to one or more of first back-stagger dimension 918, second back-stagger dimension 920, third back-stagger dimension 922, first wing dimension 1018, second wing dimension 1020, or third wing dimension 1022. For example, a multiplicative factor may be applied to the dimensions 918, 920, 922, 1018, 1020, 1022 to minimize differences in routing times across channels (e.g., the one or more electrical traces 108, or the like) of the electronic device 100. In some examples, an iterative approach may be used to apply a multiplicative factor to the dimensions and minimize routing times across the channels. Accordingly, application of the multiplicative factor may minimize time skew mismatch for the channels.

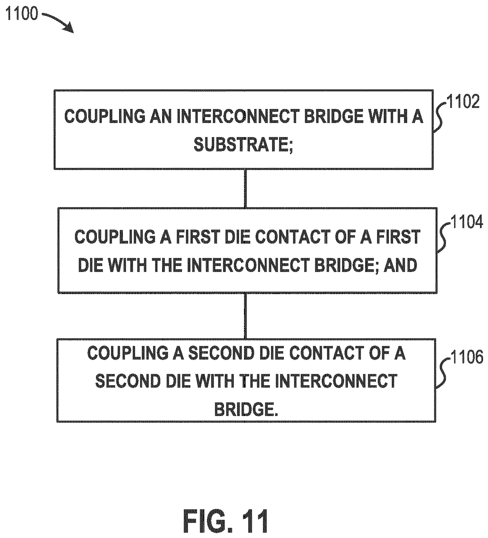

Figure 11 is one example of a method 1100 for manufacturing an electronic device, including one or more of the electronic device 100 or interconnect bridges 106 described herein. In describing the method 1100, reference is made to one or more components, features, functions and operations previously described herein. Where convenient, reference is made to the components, features, operations and the like with reference numerals. The reference numerals provided are exemplary and are not exclusive. For instance, components, features, functions, operations and the like described in the method 1100 include, but are not limited to, the corresponding numbered elements provided herein and other corresponding elements described herein (both numbered and unnumbered) as well as their equivalents.

In an example, the method 1100 includes at 1102 coupling an interconnect bridge 106 with a substrate 104. In another example, the method 1100 includes at 1104 coupling a first die contact of a first die (e.g., die 102A shown in Figure 1, or the like) with the interconnect bridge 106. At 1106, the method 1100 includes coupling a second die contact of a second die (e.g., die 102B shown in Figure 1, or the like) with the interconnect bridge 106.

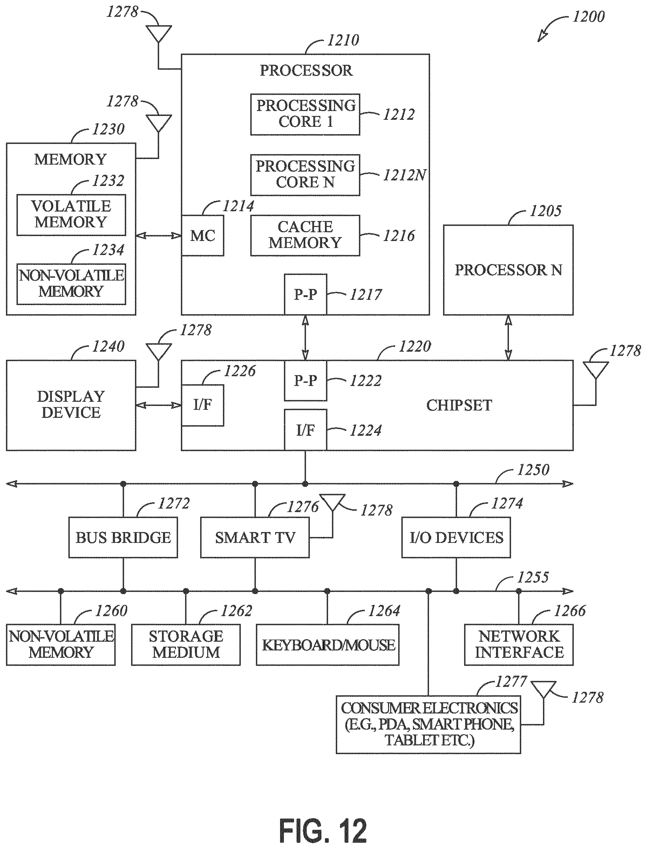

Figure 12 is a system level diagram, depicting an example of an electronic device (e.g., system) including one or more of the electronic device 100 or the interconnect bridges 106 as described in the present disclosure. Figure 12 is included to show an example of a higher level device application for one or more of the electronic device 100 or the interconnect bridges 106. In one embodiment, system 1200 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 1200 is a system on a chip (SOC) system.

In one embodiment, processor 1210 has one or more processor cores 1212 and 1212N, where 1212N represents the Nth processor core inside processor 1210 where N is a positive integer. In one embodiment, system 1200 includes multiple processors including 1210 and 1205, where processor 1205 has logic similar or identical to the logic of processor 1210. In some embodiments, processing core 1212 includes, but is not limited to, pre-fetch logic to fetch instructions, decode logic to decode the instructions, execution logic to execute instructions and the like. In some embodiments, processor 1210 has a cache memory 1216 to cache instructions and/or data for system 1200. Cache memory 1216 may be organized into a hierarchal structure including one or more levels of cache memory.

In some embodiments, processor 1210 includes a memory controller 1214, which is operable to perform functions that enable the processor 1210 to access and communicate with memory 1230 that includes a volatile memory 1232 and/or a non-volatile memory 1234. In some embodiments, processor 1210 is coupled with memory 1230 and chipset 1220. Processor 1210 may also be coupled to a wireless antenna 1278 to communicate with any device configured to transmit and/or receive wireless signals. In one embodiment, an interface for wireless antenna 1278 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 1232 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 1234 includes, but is not limited to, flash memory, phase alter memory (PCM), read-only memory (ROM), electrically erasable programmable read-only memory (EEPROM), or any other type of non-volatile memory device.

Memory 1230 stores information and instructions to be executed by processor 1210. In one embodiment, memory 1230 may also store temporary variables or other intermediate information while processor 1210 is executing instructions. In the illustrated embodiment, chipset 1220 connects with processor 1210 via Point-to-Point (PtP or P-P) interfaces 1217 and 1222. Chipset 1220 enables processor 1210 to connect to other elements in system 1200. In some embodiments of the example system, interfaces 1217 and 1222 operate in accordance with a PtP communication protocol such as the Intel^{®} QuickPath Interconnect (QPI) or the like. In other embodiments, a different interconnect may be used.

In some embodiments, chipset 1220 is operable to communicate with processor 1210, 1205N, display device 1240, and other devices, including a bus bridge 1272, a smart TV 1276, I/O devices 1274, nonvolatile memory 1260, a storage medium (such as one or more mass storage devices) 1262, a keyboard/mouse 1264, a network interface 1266, and various forms of consumer electronics 1277 (such as a PDA, smart phone, tablet etc.), etc. In one embodiment, chipset 1220 couples with these devices through an interface 1224. Chipset 1220 may also be coupled to a wireless antenna 1278 to communicate with any device configured to transmit and/or receive wireless signals.

Chipset 1220 connects to display device 1240 via interface 1226. Display 1240 may be, for example, a liquid crystal display (LCD), a plasma display, cathode ray tube (CRT) display, or any other form of visual display device. In some embodiments of the example system, processor 1210 and chipset 1220 are merged into a single SOC. In addition, chipset 1220 connects to one or more buses 1250 and 1255 that interconnect various system elements, such as I/O devices 1274, nonvolatile memory 1260, storage medium 1262, a keyboard/mouse 1264, and network interface 1266. Buses 1250 and 1255 may be interconnected together via a bus bridge 1272.

In one embodiment, mass storage device 1262 includes, but is not limited to, a solid state drive, a hard disk drive, a universal serial bus flash memory drive, or any other form of computer data storage medium. In one embodiment, network interface 1266 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in Figure 12 are depicted as separate blocks within the system 1200, the functions performed by some of these blocks may be integrated within a single semiconductor circuit or may be implemented using two or more separate integrated circuits. For example, although cache memory 1216 is depicted as a separate block within processor 1210, cache memory 1216 (or selected aspects of 1216) can be incorporated into processor core 1212.

### Various Notes & Aspects

Example 1 is an interconnect bridge, comprising: a first electrical routing trace having a first routing length and a corresponding first transit time for a first electrical signal to transmit across the first routing length, the first electrical routing trace configured to transmit the first electrical signal along a major plane of the interconnect bridge between a first interconnect and a second interconnect; and a routing trace deviation in communication with the first electrical routing trace, wherein: the routing trace deviation outside a direct route between the first interconnect and the second interconnect; and the routing trace deviation is configured to alter one or more of capacitance or resistance of the first electrical routing trace and correspondingly alter the first routing time.

In Example 2, the subject matter of Example 1 optionally includes wherein the first routing length extends predominately in a first direction, and the routing trace deviation extends away from the first direction.

In Example 3, the subject matter of Example 2 optionally includes wherein the routing trace deviation extends in a second direction, and the second direction is opposite the first direction.

In Example 4, the subject matter of any one or more of Examples 2-3 optionally include wherein at least half of the first routing length extends along the first direction.

In Example 5, the subject matter of any one or more of Examples 1-4 optionally include a second electrical trace having a second routing length and a corresponding second transit time for a second electrical signal to transit across the second routing length; the second electrical trace has a direct route between a third interconnect and a fourth interconnect; and the routing trace deviation is configured to alter the first routing time to correspond with the second routing time.

In Example 6, the subject matter of Example 5 optionally includes wherein the routing trace deviation back-staggers the first electrical routing trace.

In Example 7, the subject matter of Example 6 optionally includes wherein the first routing trace extends predominately in a first direction along the major plane of the interconnect bridge, and the routing trace deviation extends in a second direction along the major plane of the interconnect bridge.

In Example 8, the subject matter of any one or more of Examples 5-7 optionally include wherein the routing trace deviation is a capacitive-loading wing.

In Example 9, the subject matter of any one or more of Examples 7-8 optionally include wherein the capacitive-loading wing extends between a first end and a second end, the first end is coupled with the first electrical routing trace, and the second end is surrounded by a dielectric material.

In Example 10, the subject matter of any one or more of Examples 7-9 optionally include wherein the capacitive-loading wing extends between a first end and a second end, the first end is coupled with the first electrical routing trace, and the second end is electrically isolated within the interconnect bridge.

In Example 11, the subject matter of any one or more of Examples 5-10 optionally include wherein: the routing trace deviation back-staggers the first electrical routing trace; and the interconnect bridge includes a capacitive-loading wing.

Example 12 is an electronic device, comprising: a first die having a first electrical interconnect; a second die having a second electrical interconnect; an interconnect bridge facilitating electrical communication between the first die and the second die, the interconnect bridge including: a first electrical routing trace having a first routing length and a corresponding first transit time for a first electrical signal to transmit across the first routing length, the first electrical routing trace configured to transmit the first electrical signal along a major plane of the interconnect bridge between a first interconnect and a second interconnect; and a routing trace deviation in communication with the first electrical routing trace, wherein: the routing trace deviation outside a direct route between the first interconnect and the second interconnect; and the routing trace deviation is configured to alter one or more of capacitance or resistance of the first electrical routing trace and correspondingly alter the first routing time.

In Example 13, the subject matter of Example 12 optionally includes wherein the routing trace deviation back-staggers the first electrical routing trace.

In Example 14, the subject matter of Example 13 optionally includes wherein the first routing trace extends predominately in a first direction along the major plane of the interconnect bridge, and the routing trace deviation extends in a second direction along the major plane of the interconnect bridge.

In Example 15, the subject matter of any one or more of Examples 12-14 optionally include wherein the routing trace deviation is a capacitive-loading wing.

In Example 16, the subject matter of Example 15 optionally includes wherein the capacitive-loading wing extends between a first end and a second end, the first end is coupled with the first electrical routing trace, and the second end is electrically isolated within the interconnect bridge.

In Example 17, the subject matter of any one or more of Examples 12-16 optionally include wherein: the routing trace deviation back-staggers the first electrical routing trace; and the interconnect bridge includes a capacitive-loading wing.

Example 18 is a method of manufacturing an electronic device, the method comprising: coupling an interconnect bridge with a substrate, the interconnect bridge including: a first electrical routing trace having a first routing length and a corresponding first transit time for a first electrical signal to transmit across the first routing length, the first electrical routing trace configured to transmit the first electrical signal along a major plane of the interconnect bridge between a first interconnect and a second interconnect; and a routing trace deviation in communication with the first electrical routing trace, wherein: the routing trace deviation outside a direct route between the first interconnect and the second interconnect; and the routing trace deviation is configured to alter one or more of capacitance or resistance of the first electrical routing trace and correspondingly alter the first routing time; coupling a first die interconnect of a first die with the interconnect bridge; and coupling a second die interconnect of a second die with the interconnect bridge.

In Example 19, the subject matter of Example 18 optionally includes wherein the routing trace deviation back-staggers the first electrical routing trace.

In Example 20, the subject matter of any one or more of Examples 18-19 optionally include wherein the routing trace deviation is a capacitive-loading wing.

In Example 21, the subject matter of any one or more of Examples 18-20 optionally include wherein: the routing trace deviation back-staggers the first electrical routing trace; and the interconnect bridge includes a capacitive-loading wing.

Each of these non-limiting examples may stand on its own, or may be combined in various permutations or combinations with one or more of the other examples.

The above description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Geometric terms, such as "parallel", "perpendicular", "round", or "square", are not intended to require absolute mathematical precision, unless the context indicates otherwise. Instead, such geometric terms allow for variations due to manufacturing or equivalent functions. For example, if an element is described as "round" or "generally round," a component that is not precisely circular (e.g., one that is slightly oblong or is a many-sided polygon) is still encompassed by this description.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments may be combined with each other in various combinations or permutations. The scope of the invention should be determined with reference to the appended claims, along with the full scope of equivalents to which such claims are entitled.

## Claims

1. An interconnect bridge, comprising:
a first electrical routing trace having a first routing length and a corresponding first transit time for a first electrical signal to transmit across the first routing length, the first electrical routing trace configured to transmit the first electrical signal along a major plane of the interconnect bridge between a first interconnect and a second interconnect; and
a routing trace deviation in communication with the first electrical routing trace, wherein:
the routing trace deviation outside a direct route between the first interconnect and the second interconnect; and
the routing trace deviation is configured to alter one or more of capacitance or resistance of the first electrical routing trace and correspondingly alter the first routing time.

2. The interconnect bridge of claim 1, wherein the first routing length extends predominately in a first direction, and the routing trace deviation extends away from the first direction.

3. The interconnect bridge of claim 2, wherein the routing trace deviation extends in a second direction, and the second direction is opposite the first direction.

4. The interconnect bridge of claim 2 or 3, wherein at least half of the first routing length extends along the first direction.

5. The interconnect bridge of one of the claims 1-4, further comprising:
a second electrical trace having a second routing length and a corresponding second transit time for a second electrical signal to transit across the second routing length;
the second electrical trace has a direct route between a third interconnect and a fourth interconnect; and
the routing trace deviation is configured to alter the first routing time to correspond with the second routing time.

6. The interconnect bridge of one of the claims 1-5, wherein the routing trace deviation back-staggers the first electrical routing trace.

7. The interconnect bridge of one of the claims 1-6, wherein the first routing trace extends predominately in a first direction along the major plane of the interconnect bridge, and the routing trace deviation extends in a second direction along the major plane of the interconnect bridge.

8. The interconnect bridge of one of the claims 1-7, wherein the routing trace deviation is a capacitive-loading wing.

9. The interconnect bridge of claim 7, wherein the capacitive-loading wing extends between a first end and a second end, the first end is coupled with the first electrical routing trace, and the second end is surrounded by a dielectric material.

10. The interconnect bridge of claim 7 or 8, wherein the capacitive-loading wing extends between a first end and a second end, the first end is coupled with the first electrical routing trace, and the second end is electrically isolated within the interconnect bridge.

11. The interconnect bridge of one of the claims 1-10, wherein:
the routing trace deviation back-staggers the first electrical routing trace; and
the interconnect bridge includes a capacitive-loading wing.

12. An electronic device, comprising:
a first die having a first electrical interconnect;
a second die having a second electrical interconnect;
an interconnect bridge facilitating electrical communication between the first die and the second die, the interconnect bridge including:
a first electrical routing trace having a first routing length and a corresponding first transit time for a first electrical signal to transmit across the first routing length, the first electrical routing trace configured to transmit the first electrical signal along a major plane of the interconnect bridge between a first interconnect and a second interconnect; and
a routing trace deviation in communication with the first electrical routing trace, wherein:
the routing trace deviation outside a direct route between the first interconnect and the second interconnect; and
the routing trace deviation is configured to alter one or more of capacitance or resistance of the first electrical routing trace and correspondingly alter the first routing time.

13. The electronic device of claim 12, wherein the routing trace deviation back-staggers the first electrical routing trace.

14. The electronic device of claim 13, wherein the first routing trace extends predominately in a first direction along the major plane of the interconnect bridge, and the routing trace deviation extends in a second direction along the major plane of the interconnect bridge.

15. A method of manufacturing an electronic device, the method comprising:
coupling an interconnect bridge with a substrate, the interconnect bridge including:
a first electrical routing trace having a first routing length and a corresponding first transit time for a first electrical signal to transmit across the first routing length, the first electrical routing trace configured to transmit the first electrical signal along a major plane of the interconnect bridge between a first interconnect and a second interconnect; and
a routing trace deviation in communication with the first electrical routing trace, wherein:
the routing trace deviation outside a direct route between the first interconnect and the second interconnect; and
the routing trace deviation is configured to alter one or more of capacitance or resistance of the first electrical routing trace and
correspondingly alter the first routing time;
coupling a first die interconnect of a first die with the interconnect bridge; and
coupling a second die interconnect of a second die with the interconnect bridge.
